# EUROPEAN PATENT APPLICATION

(11) **EP 4 451 661 A1**
(43) Date of publication of application: **23.10.2024**
(21) Application number: 23211005.6
(22) Date of filing: 20.11.2023
(51) Int. Cl.: H04N 1/00, H05K 13/08

(54) **INFORMATION PROCESSING SYSTEM, PROGRAM, AND INFORMATION PROCESSING METHOD**

(30) Priority: 21.04.2023 JP 2023070466
(71) Applicant: FUJIFILM Business Innovation Corp., Minato-ku Tokyo (JP)
(72) Inventor: YAMAGUCHI, Megumi, Yokohama-shi (JP); NOGUCHI, Daisuke, Yokohama-shi (JP); NAKAYAMA, Hiroyoshi, Yokohama-shi (JP); KAWABE, Masatake, Yokohama-shi (JP)
(74) Representative: Haseltine Lake Kempner LLP

(57) **Abstract**

An information processing system includes a processor configured to: obtain instruction information for an image forming apparatus and an inspection result within a range of a setting condition which has been set in advance, the inspection result being obtained by an inspection apparatus which inspects an image formed on a recording medium by the image forming apparatus on the basis of the instruction information; and output an abnormality monitoring result obtained in accordance with division-by-division-basis counts of abnormalities in an inspection, the divisions being obtained by dividing an inspection area inspected by the inspection apparatus.

## Description

### Background

### (i) Technical Field

The present disclosure relates to an information processing system, a program, and an information processing method.

### (ii) Related Art

Japanese Patent No. 4161884 discloses a solder inspection apparatus. In solder inspection for inspecting the print states of solder printed on substrates, for each substrate, the solder inspection apparatus accumulatively stores a determination result, which is obtained from the inspection, about the electrodes on the substrate. In reference of inspection result information, the solder inspection apparatus displays the accumulated determination result on a solder print position map in a screen, and displays no-good (NG) occurrence positions and occurrence frequencies by using the positions and the sizes of balloon marks. When necessary, the solder inspection apparatus further displays detailed information, such as association with the print direction and NG types.

### Summary

Accordingly, it is an object of the present disclosure to provide a technique for founding an abnormality of an inspection apparatus with high accuracy, compared with the case in which abnormalities are detected only on the basis of the number of recording media having abnormalities detected in an inspection.

According to a first aspect of the present disclosure, there is provided an information processing system comprising: a processor configured to: obtain instruction information for an image forming apparatus and an inspection result within a range of a setting condition which has been set in advance, the inspection result being obtained by an inspection apparatus which inspects an image formed on a recording medium by the image forming apparatus on a basis of the instruction information; and output an abnormality monitoring result obtained in accordance with division-by-division-basis counts of abnormalities in an inspection, the divisions being obtained by dividing an inspection area inspected by the inspection apparatus.

According to a second aspect of the present disclosure, in the information processing system of the first aspect, the processor is configured to: when a division-by-division-basis count among the division-by-division-basis counts of abnormalities in the inspection is greater than or equal to a specified number of inspections performed by the inspection apparatus, notify, as the abnormality monitoring result, possibility of an abnormality of the inspection apparatus.

According to a third aspect of the present disclosure, in the information processing system of the first aspect, the processor is configured to: when a ratio of a division-by-division-basis count among the division-by-division-basis counts of abnormalities in the inspection with respect to a count of inspections performed by the inspection apparatus is greater than or equal to a threshold, notify possibility of an abnormality of the inspection apparatus.

According to a fourth aspect of the present disclosure, in the information processing system of any one of the first to third aspects, the setting condition is a number of jobs or a number of days.

According to a fifth aspect of the present disclosure, in the information processing system of the fourth aspect, the processor is configured to: even in the middle of the number of jobs or in the middle of the number of days, notify possibility of an abnormality of the inspection apparatus on a basis of the division-by-division-basis counts of abnormalities in the inspection.

According to a sixth aspect of the present disclosure, in the information processing system of the fourth aspect, the processor is configured to: when abnormalities occur in an identical division across jobs whose number is within the number of jobs, or when abnormalities occur in an identical division across days whose number is within the number of days, notify possibility of an abnormality of the inspection apparatus.

According to a seventh aspect of the present disclosure, in the information processing system of any one of the first to sixth aspects, the processor is configured to: generate a heat map as the abnormality monitoring result on a basis of the division-by-division-basis counts of abnormalities in the inspection, and notify possibility of an abnormality of the inspection apparatus.

According to an eighth aspect of the present disclosure, in the information processing system of the seventh aspect, the heat map is formed of divisions, each of which is larger than each division obtained by dividing the inspection area.

According to a ninth aspect of the present disclosure, there is provided a program causing a computer to execute a process comprising: obtaining instruction information for an image forming apparatus and an inspection result within a range of a setting condition which has been set in advance, the inspection result being obtained by an inspection apparatus which inspects an image formed on a recording medium by the image forming apparatus on a basis of the instruction information; and outputting an abnormality monitoring result obtained in accordance with division-by-division-basis counts of abnormalities in an inspection, the divisions being obtained by dividing an inspection area inspected by the inspection apparatus.

According to a tenth aspect of the present disclosure, there is provided an information processing method comprising: obtaining instruction information for an image forming apparatus and an inspection result within a range of a setting condition which has been set in advance, the inspection result being obtained by an inspection apparatus which inspects an image formed on a recording medium by the image forming apparatus on a basis of the instruction information; and outputting an abnormality monitoring result obtained in accordance with division-by-division-basis counts of abnormalities in an inspection, the divisions being obtained by dividing an inspection area inspected by the inspection apparatus.

Compared with the case in which abnormalities are detected only on the basis of the number of recording media having abnormalities detected in an inspection, the information processing system according to the first aspect causes an abnormality of the inspection apparatus to be found with high accuracy.

Compared with the case in which abnormalities are detected only on the basis of the number of recording media having abnormalities detected in an inspection, the information processing system according to the second aspect causes an abnormality of the inspection apparatus to be found with high accuracy.

Even in the case of recording media having different sizes, the information processing system according to the third aspect causes an abnormality of the inspection apparatus to be found with high accuracy.

Compared with the case in which the number of sheets on which images are to be formed is set to the setting condition, the information processing system according to the fourth aspect causes an abnormality of the inspection apparatus to be found with high accuracy.

Even in the case where a division-by-division-basis count of abnormalities detected in an inspection reaches the reference value in the middle of the set number of jobs or in the middle of the set number of days, the information processing system according to the fifth aspect causes possibility of an abnormality of the inspection apparatus to be notified.

Compared with the case in which an abnormality is determined only in a single job, the information processing system according to the sixth aspect causes suppression of possibility of erroneous notification of possibility of an abnormality of the inspection apparatus.

Compared with the case in which the division-by-division-basis counts of abnormalities in an inspection are displayed as numeric values, the information processing system according to the seventh aspect causes an abnormality of the inspection apparatus to be found with high accuracy.

Compared with the case in which a heat map is formed of small-size divisions as they are, the information processing system according to the eighth aspect causes a user to grasp the positions of abnormalities easily.

Compared with the case in which abnormalities are detected only on the basis of the number of recording media having abnormalities detected in an inspection, the program according to the ninth causes an abnormality of the inspection apparatus to be found with high accuracy.

Compared with the case in which abnormalities are detected only on the basis of the number of recording media having abnormalities detected in an inspection, the information processing method according to the tenth aspect causes an abnormality of the inspection apparatus to be found with high accuracy.

### Brief Description of the Drawings

Exemplary embodiments of the present disclosure will be described in detail based on the following figures, wherein:
Fig. 1 is a schematic diagram illustrating the configuration of an information processing system according to a first exemplary embodiment;
Fig. 2 is a diagram illustrating a setting screen for a setting condition according to the first exemplary embodiment;
Fig. 3 is a block diagram illustrating the functional configuration of an information processing apparatus according to the first exemplary embodiment;
Fig. 4 is a diagram for describing an inspection area according to the first exemplary embodiment;
Fig. 5 is a diagram illustrating divisions in an inspection area and divisions in a heat map according to the first exemplary embodiment;
Fig. 6 is a diagram illustrating an output screen of an abnormality monitoring result according to the first exemplary embodiment;
Fig. 7 is a flowchart of a process performed by an information processing apparatus according to the first exemplary embodiment;
Fig. 8 is a flowchart of a process performed by an information processing apparatus according to a second exemplary embodiment;
Fig. 9 is a flowchart of a process performed by an information processing apparatus according to a third exemplary embodiment;
Fig. 10 is a diagram illustrating a setting screen for a setting condition according to a different exemplary embodiment; and
Fig. 11 is a diagram illustrating an output screen of an abnormality monitoring result according to a different exemplary embodiment.

### Detailed Description

### First Exemplary Embodiment

An information processing system according to a first exemplary embodiment will be described below by referring to drawings. In the first exemplary embodiment, an example in which an information processing system 10 monitors abnormalities of an inspection result for images formed on recording media by an image forming apparatus 12.

### The Configuration of the Information Processing System

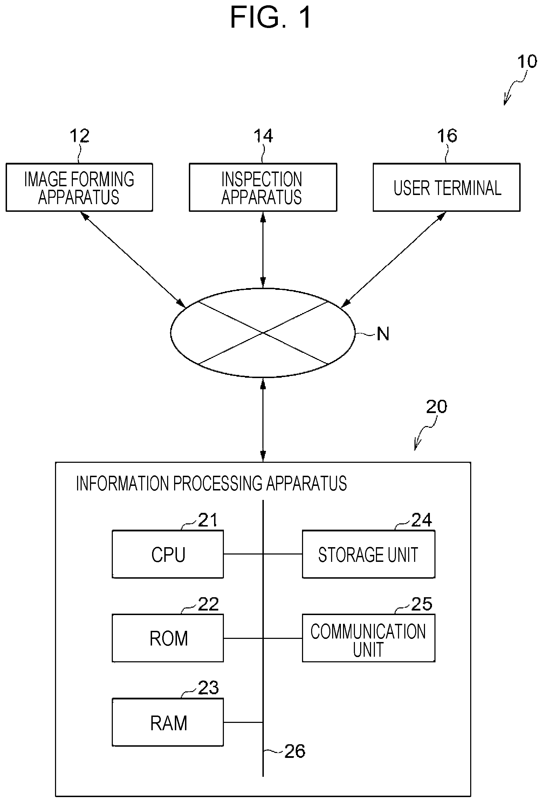

As illustrated in Fig. 1, the information processing system 10 includes the image forming apparatus 12, an inspection apparatus 14, a user terminal 16, and an information processing apparatus 20.

The image forming apparatus 12, the inspection apparatus 14, the user terminal 16, and the information processing apparatus 20 are communicatively connected to each other over a network N.

### The Image Forming Apparatus 12

The image forming apparatus 12 is, for example, a production printer which performs commercial printing. The image forming apparatus 12 forms images on recording media in accordance with instruction information from the information processing apparatus 20. The instruction information is necessary for image formation on a recording medium. Examples of instruction information include image data, the recording medium type, the number of sheets to be printed, the recording medium size, and monochrome printing or color printing. The instruction information may be received by the information processing apparatus 20 or the image forming apparatus 12 from an external terminal over the network N.

### The Inspection Apparatus 14

The inspection apparatus 14 inspects images formed by the image forming apparatus 12. The inspection apparatus 14 captures an image, which is formed on a recording medium, for example, by using an image sensor or a camera, and compares the captured image with image data received by the image forming apparatus 12. Thus, for example, the inspection apparatus 14 inspects smudges and scratches in the captured image. An inspection result from the inspection apparatus 14 includes the positions of abnormalities in an image formed on a recording medium.

### The User Terminal 16

The user terminal 16, which is, for example, a personal computer (PC), a tablet terminal, or a smartphone, is used by a user such as a maintenance staff member who maintains and manages the image forming apparatus 12. The user may use the user terminal 16 to input a setting condition to the information processing apparatus 20. The setting condition, which is predetermined, may be set through a user's input using the user terminal 16, or may be set in advance before shipment of the information processing system 10. The setting condition may be the number of jobs.

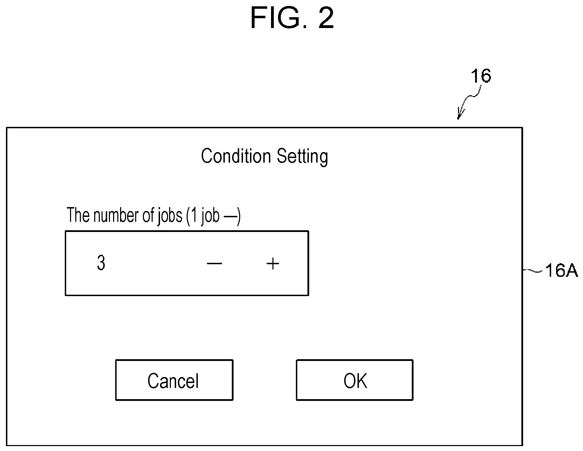

As illustrated in Fig. 2, the user terminal 16 includes a display 16A. The display 16A displays a setting screen for the number of jobs which is input by a user. On the display 16A, information, which has been processed by the information processing apparatus 20, is output.

### The Information Processing Apparatus 20

The information processing apparatus 20 functions as a server, such as a web server or a database server. The information processing apparatus 20 includes a central processing unit (CPU) 21 as a processor, a read only memory (ROM) 22, a random access memory (RAM) 23, a storage unit 24, and a communication unit 25. The configurations are communicatively connected to each other through a bus 26.

The CPU 21, which is a central processing unit, runs various programs and controls the units. The CPU 21 reads programs from the ROM 22 or the storage unit 24, and runs programs by using the RAM 23 as a work area. The CPU 21 controls the configurations and performs various computations according to programs recorded in the ROM 22 or the storage unit 24.

The ROM 22 stores various programs and various data. The RAM 23, serving as a work area, temporarily stores programs or data.

The storage unit 24 is constituted by a storage device, such as a hard disk drive (HDD), a solid state drive (SSD), or a flash memory, and stores various programs and various data. The storage unit 24 stores programs for performing an inspection abnormality monitoring process described below.

The communication unit 25 is an interface for communicating with the image forming apparatus 12, the inspection apparatus 14, and the user terminal 16 over the network N.

### The Functional Configuration of the Information Processing Apparatus

The information processing apparatus 20 receives the instruction information, which is received by the image forming apparatus 12, an inspection result from the inspection apparatus 14, and the number of jobs, which is input on the user terminal 16, over the network N, and outputs, to the user terminal 16 over the network N, a processing result of the inspection abnormality monitoring process performed by the information processing apparatus 20. In the information processing apparatus 20, the CPU 21 performs the inspection abnormality monitoring process according to programs recorded in the ROM 22 or the storage unit 24.

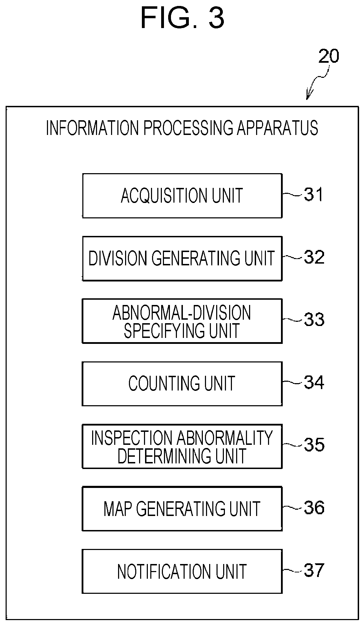

As illustrated in Fig. 3, the information processing apparatus 20 functionally includes an acquisition unit 31, a division generating unit 32, an abnormal-division specifying unit 33, a counting unit 34, an inspection abnormality determining unit 35, a map generating unit 36, and a notification unit 37.

### The Acquisition Unit 31

The acquisition unit 31 acquires the instruction information for the image forming apparatus 12. On the basis of the instruction information, the acquisition unit 31 acquires an inspection result, from the inspection apparatus 14, of images formed on recording media by the image forming apparatus 12. The acquisition unit 31 acquires the number of jobs which is input on the user terminal 16. In other words, the acquisition unit 31 acquires, within the range of the number of jobs which is input on the user terminal 16, the instruction information for the image forming apparatus 12 and inspection results from the inspection apparatus 14.

The acquisition unit 31 may acquire, within the range of the number of jobs which is set in advance, the instruction information for the image forming apparatus 12 and inspection results from the inspection apparatus 14.

### The Division Generating Unit 32

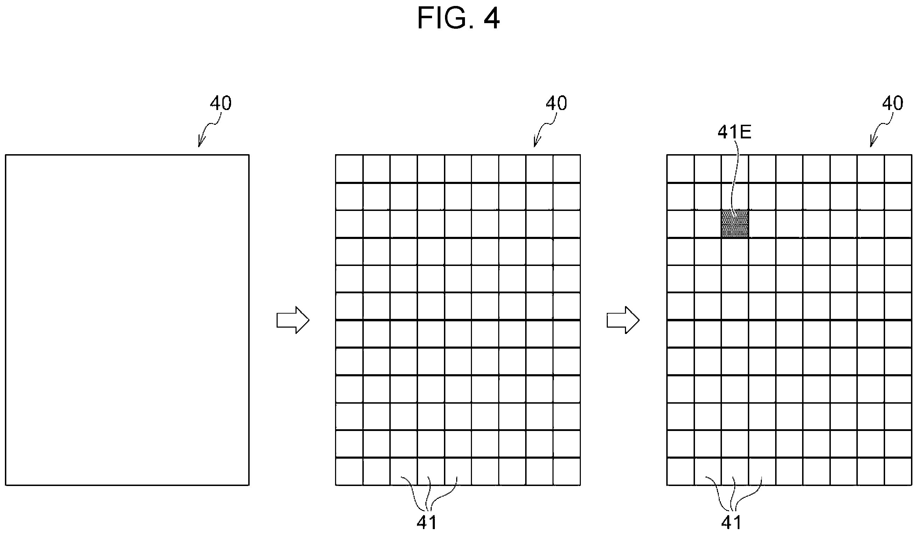

As illustrated in Fig. 4, the division generating unit 32 divides an inspection area 40 inspected by the inspection apparatus 14, and generates multiple divisions 41. The division generating unit 32 divides an inspection area 40 corresponding to a recording medium, and generates multiple divisions 41.

### The Abnormal-Division Specifying Unit 33

As illustrated in Fig. 4, the abnormal-division specifying unit 33 specifies abnormal divisions 41E, which correspond to the positions (NG positions) of abnormalities detected in an inspection, among the divisions 41 on the basis of the inspection result from the inspection apparatus 14. Specifically, when the inspection result from the inspection apparatus 14 includes NG positions, the abnormal-division specifying unit 33 specifies, as abnormal divisions 41E, the divisions 41 corresponding to the positions of the abnormalities detected in the inspection.

### The Counting Unit 34

The counting unit 34 counts jobs in which the image forming apparatus 12 has formed images on recording media. The counting unit 34 determines whether the count of jobs, in which the image forming apparatus 12 has formed images on recording media, has reached the number of jobs which is input and set on the user terminal 16.

The counting unit 34 counts occurrences of abnormal divisions 41E within the range of the number of jobs which is input on the user terminal 16. In other words, the counting unit 34 counts abnormalities, which are detected in an inspection, for each division within the range of the number of jobs which is input on the user terminal 16.

### The Inspection Abnormality Determining Unit 35

The inspection abnormality determining unit 35 determines an abnormality of the inspection apparatus 14 on the basis of the count of occurrences of abnormal divisions 41E. Specifically, when, within the range of the number of jobs which is input on the user terminal 16, a division-by-division-basis count of abnormalities, which are detected in an inspection, is greater than or equal to a specified number of inspections performed by the inspection apparatus 14, the inspection abnormality determining unit 35 determines that the inspection apparatus 14 is highly likely to be abnormal. The specified number of inspections may be set by a user, and, for example, may be input on the user terminal 16.

When, within the range of the number of jobs which is input on the user terminal 16, a division-by-division-basis count of abnormalities, which are detected in an inspection, is greater than or equal to the number of inspections performed by the inspection apparatus 14, the inspection abnormality determining unit 35 may determine that the inspection apparatus 14 is highly likely to be abnormal.

In the case of a high frequency of reception of jobs using different sizes of recording media, when the ratio of a division-by-division-basis count of abnormalities, which are detected in an inspection, with respect to the number of inspections performed by the inspection apparatus 14 is greater than or equal to a threshold, the inspection abnormality determining unit 35 may determine that the inspection apparatus 14 is highly likely to be abnormal.

When abnormalities have occurred in the same division 41 across jobs whose number is within the number of jobs, the inspection abnormality determining unit 35 may determine that the inspection apparatus 14 is highly likely to be abnormal. In this case, the inspection abnormality determining unit 35 may put weights on the division-by-division-basis counts of abnormalities, which are detected in an inspection, and may determine possibility of an abnormality of the inspection apparatus 14.

### The Map Generating Unit 36

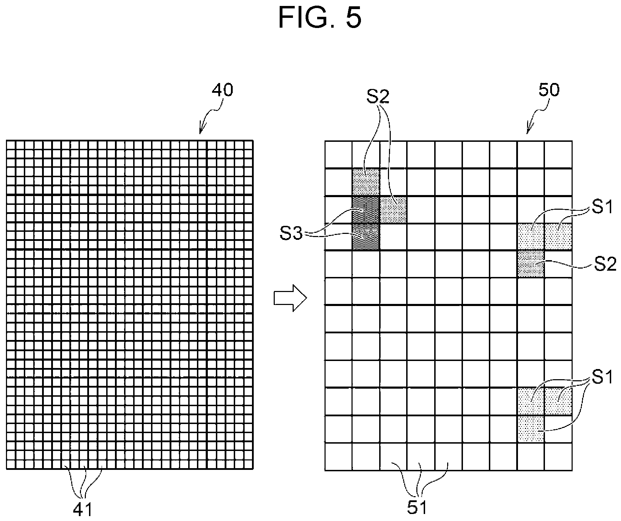

As illustrated in Fig. 5, the map generating unit 36 generates a heat map 50, serving as an abnormality monitoring result, on the basis of the division-by-division-basis counts of abnormalities which are detected in an inspection. For example, when a division-by-division-basis count of abnormalities detected in an inspection is greater than a first threshold, the map generating unit 36 generates a corresponding yellow division S1 obtained by making the color of a division 51 yellow in the heat map 50. When a division-by-division-basis count of abnormalities detected in an inspection is greater than a second threshold which is greater than the first threshold, the map generating unit 36 generates a corresponding orange division S2 obtained by making the color of a division 51 orange in the heat map 50. When a division-by-division-basis count of abnormalities detected in an inspection is greater than a third threshold which is greater than the second threshold, the map generating unit 36 generates a corresponding red division S3 obtained by making the color of a division 51 red in the heat map 50.

As illustrated in Fig. 5, a division 51 in the heat map 50 may be larger than a division 41 in the inspection area 40.

### The Notification Unit 37

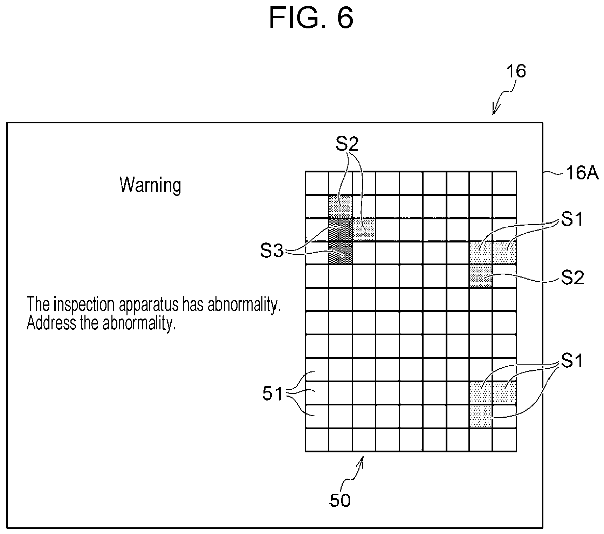

As illustrated in Fig. 6, the notification unit 35 outputs the heat map 50 on the display 16A of the user terminal 16, and notifies the determination result from the inspection abnormality determining unit 35.

That is, the information processing apparatus 20 outputs an abnormality monitoring result obtained in accordance with the division-by-division-basis counts of abnormalities detected in an inspection. The divisions are obtained by dividing the inspection area 40 inspected by the inspection apparatus 14. When it is determined that the determination result from the inspection abnormality determining unit 35 indicates abnormality, the information processing apparatus 20 may output the determination result as an abnormality monitoring result. Alternatively, even when it is determined that the determination result from the inspection abnormality determining unit 35 indicates no abnormality, the information processing apparatus 20 may output the determination result as an abnormality monitoring result.

### The Flow of the Inspection Abnormality Monitoring Process

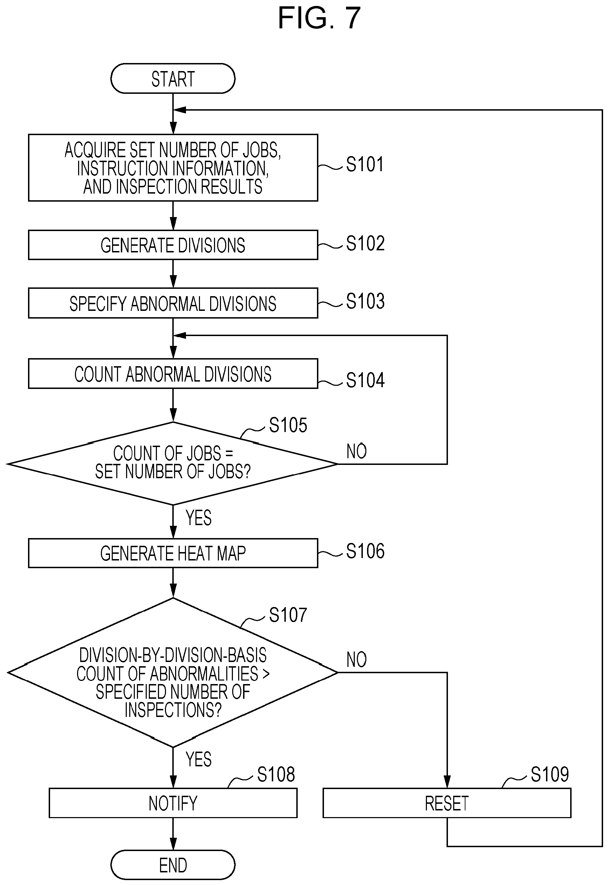

As illustrated in Fig. 7, when the inspection abnormality monitoring process starts, the acquisition unit 31 acquires the number of jobs, which is input on the user terminal 16, instruction information, which is received by the image forming apparatus 12, and inspection results from the inspection apparatus 14 (step S101).

The division generating unit 32 divides the inspection area 40 inspected by the inspection apparatus 14, and generates multiple divisions 41 (step S102).

The abnormal-division specifying unit 33 specifies abnormal divisions 41E, which correspond to the positions of abnormalities detected in the inspection, among the divisions 41 on the basis of the inspection results from the inspection apparatus 14 (step S103).

The counting unit 34 counts occurrences of abnormal divisions 41E (step S104).

The counting unit 34 determines whether the count of jobs, in which the image forming apparatus 12 has formed images on recording media, has reached the number of jobs, which is input and set on the user terminal 16 (step S105). If it is determined that the count of jobs, in which the image forming apparatus 12 has formed images on recording media, has reached the number of jobs, which is input and set on the user terminal 16 (YES in step S105), the process proceeds to step S106. In contrast, if the count of jobs, in which the image forming apparatus 12 has formed images on recording media, has not reached the number of jobs, which is input and set on the user terminal 16 (NO in step S105), the process returns to step S104.

In step S106, the map generating unit 36 generates a heat map 50 on the basis of the division-by-division-basis counts of abnormalities detected in the inspection.

Within the range of the number of jobs which is input on the user terminal 16, the inspection abnormality determining unit 35 determines whether a division-by-division-basis count of abnormalities, which are detected in the inspection, is greater than or equal to the specified number of inspections performed by the inspection apparatus 14 (step S107). If it is determined that a division-by-division-basis count of abnormalities, which are detected in the inspection, is greater than or equal to the specified number of inspections performed by the inspection apparatus 14 (YES in step S107), the process proceeds to step S108. In contrast, if it is determined that each division-by-division-basis count of abnormalities, which are detected in the inspection, is less than the specified number of inspections performed by the inspection apparatus 14 (NO in step S107), the process proceeds to step S109.

In step S108, the notification unit 35 outputs the heat map 50 to the user terminal 16, and notifies the determination result from the inspection abnormality determining unit 35 (step S108). Then, the inspection abnormality monitoring process ends.

In step S109, the information processing apparatus 20 resets counting information used by the counting unit 34, and the process returns to step S101.

### Operation

An inspection result, of the related art, of a recording medium on which an image has been formed includes an abnormality occurring due to an abnormality of the image forming apparatus 12, and an abnormality occurring due to an abnormality of an inspection apparatus which inspects the image formed on the recording medium. Therefore, it is difficult to determine whether the image forming apparatus 12 has an abnormality or the inspection apparatus 14 has an abnormality. In this case, it may take time to specify which apparatus has an abnormality, or the reason may have to be identified depending on the experience of a worker.

In the information processing system 10 according to the first exemplary embodiment, the CPU 21 obtains, within the range of the setting condition which has been set in advance, instruction information for the image forming apparatus 12 and an inspection result, from the inspection apparatus 14, of images formed on recording media by the image forming apparatus 12 on the basis of the instruction information. Then, the CPU 21 outputs the abnormality monitoring result obtained in accordance with the division-by-division-basis counts of abnormalities detected in the inspection. The divisions are obtained by dividing the inspection area 40 inspected by the inspection apparatus 14 (see Fig. 6).

The CPU 21 outputs the abnormality monitoring result obtained in accordance with the division-by-division basis counts of abnormalities detected in an inspection. The divisions are obtained by dividing the inspection area 40 inspected by the inspection apparatus 14. Thus, when abnormalities, which are detected in an inspection, frequently occur in the same division 41 within the range of the setting condition which has been set in advance, the CPU 21 notifies possibility of an abnormality of the inspection apparatus 14. Then, the positions of abnormalities are determined by using the small-size divisions 41. Therefore, compared with the case in which abnormalities are detected only on the basis of the number of recording media having abnormalities detected in an inspection, an abnormality of the inspection apparatus is found with high accuracy.

In the information processing system 10 according to the first exemplary embodiment, when a division-by-division-basis count of abnormalities, which are detected in an inspection, is greater than or equal to the specified number of inspections performed by the inspection apparatus 14, the CPU 21 notifies possibility of an abnormality of the inspection apparatus 14 (see Fig. 7).

When a division-by-division-basis count of abnormalities, which are detected in an inspection, is greater than or equal to the specified number of inspections performed by the inspection apparatus 14, the CPU 21 notifies possibility of an abnormality of the inspection apparatus 14. Thus, when abnormalities, which are detected in an inspection, frequently occur in the same division 41, the CPU 21 notifies possibility of an abnormality of the inspection apparatus 14. Therefore, compared with the case in which abnormalities are detected only on the basis of the number of recording media having abnormalities detected in an inspection, an abnormality of the inspection apparatus is found with high accuracy.

In the information processing system 10 according to the first exemplary embodiment, the setting condition is the number of jobs (see Fig. 2).

The setting condition is the number of jobs. Thus, within the range of the number of jobs which has been set, when abnormalities, which are detected in an inspection, frequently occur in the same division 41, possibility of an abnormality of the inspection apparatus 14 is notified. Therefore, compared with the case in which the number of sheets, on which images are formed, is set to the setting condition, an abnormality of the inspection apparatus is found with high accuracy.

In the information processing system 10 according to the first exemplary embodiment, the CPU 21 generates the heat map 50 on the basis of the division-by-division-basis counts of abnormalities detected in an inspection, and notifies possibility of an abnormality of the inspection apparatus 14 (see Fig. 6).

The CPU 21 generates the heat map 50 on the basis of the division-by-division-basis counts of abnormalities detected in an inspection, and notifies possibility of an abnormality of the inspection apparatus 14. Thus, the division-by-division-basis counts of abnormalities detected in an inspection are displayed in the heat map 50. Therefore, compared with the case in which the division-by-division-basis counts of abnormalities detected in an inspection are displayed as numeric values, an abnormality of the inspection apparatus is found with high accuracy.

In the information processing system 10 according to the first exemplary embodiment, the heat map 50 is constituted by divisions 51, each of which is larger than a division 41 in the inspection area 40 (see Fig. 5).

The heat map 50 is formed by using divisions 51, each of which is larger than a division 41 in the inspection area 40. Thus, compared with the case in which a heat map is formed by using the small-size divisions as they are, a user easily grasps the positions of abnormalities.

### Second Exemplary Embodiment

An information processing system according to a second exemplary embodiment is different from that according to the first exemplary embodiment in that the flow of the inspection abnormality monitoring process is different. The components, which are the same as or equivalent to those described in the first exemplary embodiment, will be described by using the same terms or the same reference numerals.

### The Flow of the Inspection Abnormality Monitoring Process

In the flow of the inspection abnormality monitoring process according to the second exemplary embodiment, the processes from step S101 to step S104 are substantially the same as those in the flow of the inspection abnormality monitoring process according to the first exemplary embodiment.

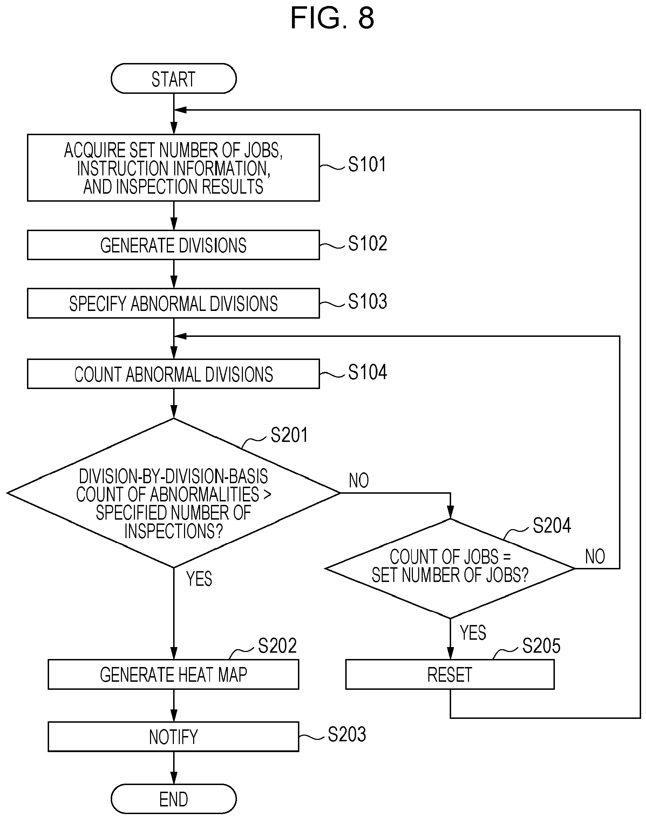

As illustrated in Fig. 8, in step S201, within the range of the number of jobs which is input on the user terminal 16, the inspection abnormality determining unit 35 determines whether a division-by-division-basis count of abnormalities detected in the inspection is greater than or equal to the specified number of inspections performed by the inspection apparatus 14. If it is determined that a division-by-division-basis count of abnormalities detected in the inspection is greater than or equal to the specified number of inspections performed by the inspection apparatus 14 (YES in step S201), the process proceeds to step S202. In contrast, if each division-by-division-basis count of abnormalities detected in the inspection is less than the specified number of inspections performed by the inspection apparatus 14 (NO in step S201), the process proceeds to step S204.

In step S202, the map generating unit 36 generates a heat map 50 on the basis of the division-by-division-basis counts of abnormalities detected in the inspection.

The notification unit 35 outputs the heat map 50 to the user terminal 16, and notifies the determination result from the inspection abnormality determining unit 35 (step S203). Then, the inspection abnormality monitoring process ends.

In step S204, the counting unit 34 determines whether the count of jobs, in which the image forming apparatus 12 has formed images on recording media, has reached the number of jobs, which is input and set on the user terminal 16 (step S204). If it is determined that the count of jobs, in which the image forming apparatus 12 has formed images on recording media, has reached the number of jobs, which is input and set on the user terminal 16 (YES in step S204), the process proceeds to step S205. In contrast, if it is determined that the count of jobs, in which the image forming apparatus 12 has formed images on recording media, has not reached the number of jobs, which is input and set on the user terminal 16 (NO in step S205), the process returns to step S104.

In step S205, the information processing apparatus 20 resets the counting information used by the counting unit 34, and the process returns to step S101.

### Operation

In a manufacture process such as production printing, a large amount of printing may be output in a single job. In this case, a count of abnormalities detected in an inspection may reach a reference value in the single job. In this case, even when the image forming apparatus 12 has an abnormality, possibility of an abnormality of the inspection apparatus 14 is notified.

In the information processing system 10 according to the second exemplary embodiment, the CPU 21 notifies possibility of an abnormality of the inspection apparatus 14 on the basis of the division-by-division-basis counts of abnormalities detected in an inspection even in the middle of the number of jobs (see Fig. 8).

Even in the middle of the number of jobs, the CPU 21 notifies possibility of an abnormality of the inspection apparatus 14 on the basis of the division-by-division-basis counts of abnormalities detected in an inspection. Thus, even in the case where a division-by-division-basis count of abnormalities detected in an inspection has reached the reference value in the middle of the set number of jobs, possibility of an abnormality of the inspection apparatus is notified.

The other configuration and operational effect are substantially the same as those of the first exemplary embodiment, and will not be described.

### Third Exemplary Embodiment

An information processing system according to a third exemplary embodiment is different from that according to the first exemplary embodiment in that the flow of the inspection abnormality monitoring process is different. The components, which are the same as or equivalent to those described in the first exemplary embodiment, are described by using the same terms or the same reference numerals.

### The Flow of the Inspection Abnormality Monitoring Process

In the flow of the inspection abnormality monitoring process according to the third exemplary embodiment, the processes from step S101 to step S106 are substantially the same as those according to the first exemplary embodiment.

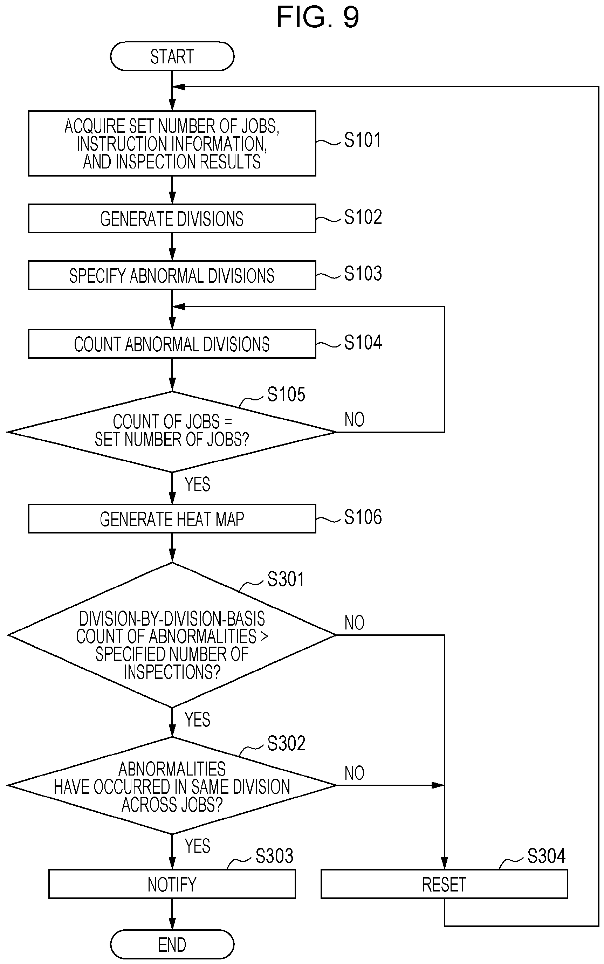

As illustrated in Fig. 9, in step S301, within the range of the number of jobs which is input on the user terminal 16, the inspection abnormality determining unit 35 determines whether a division-by-division-basis count of abnormalities detected in the inspection is greater than or equal to the specified number of inspections performed by the inspection apparatus 14. If it is determined that a division-by-division-basis count of abnormalities detected in the inspection is greater than or equal to the specified number of inspections performed by the inspection apparatus 14 (YES in step S301), the process proceeds to step S302. In contrast, if it is determined that each division-by-division-basis count of abnormalities detected in the inspection is less than the specified number of inspections performed by the inspection apparatus 14 (NO in step S301), the process proceeds to step S304.

In step S302, the inspection abnormality determining unit 35 determines whether abnormalities have occurred in the same division 41 across jobs whose number is within the number of jobs. If it is determined that abnormalities have occurred in the same division 41 across jobs whose number is within the number of jobs (YES in step S302), the process proceeds to step S303. In contrast, if it is determined that abnormalities have not occurred in the same division 41 across jobs whose number is within the number of jobs (NO in step S302), the process proceeds to step S304.

In step S303, the notification unit 35 outputs the heat map 50 to the user terminal 16, and notifies the determination result from the inspection abnormality determining unit 35 (step S303). Then, the inspection abnormality monitoring process ends.

In step S304, the information processing apparatus 20 resets the counting information used by the counting unit 34, and the process returns to step S101.

### Operation

In a manufacture process such as production printing, a large amount of printing may be output in a single job. In this case, a count of abnormalities detected in an inspection may reach a reference value in the single job or in a single day. In this case, even when the image forming apparatus 12 has an abnormality, possibility of an abnormality of the inspection apparatus 14 is notified.

In the information processing system 10 according to the third exemplary embodiment, when abnormalities occur in the same division 41 across jobs whose number is within the number of jobs, the CPU 21 notifies possibility of an abnormality of the inspection apparatus 14 (see Fig. 9).

When abnormalities occur in the same division 41 across jobs whose number is within the number of jobs, the CPU 21 notifies possibility of an abnormality of the inspection apparatus 14. Thus, even when a count of abnormalities detected in an inspection has reached the reference value in a single job, possibility of an abnormalities of the inspection apparatus 14 is not notified. Therefore, compared with the case in which an abnormality is determined only in a single job, possibility of erroneous notification of possibility of an abnormality of the inspection apparatus 14 is suppressed.

The other configuration and operational effect are substantially the same as those in the first exemplary embodiment, and will not be described.

As described above, specific exemplary embodiments of the present disclosure are described. The present disclosure is not limited to the exemplary embodiments described above. Various modifications, changes, and improvements may be made within the technical idea of the present disclosure.

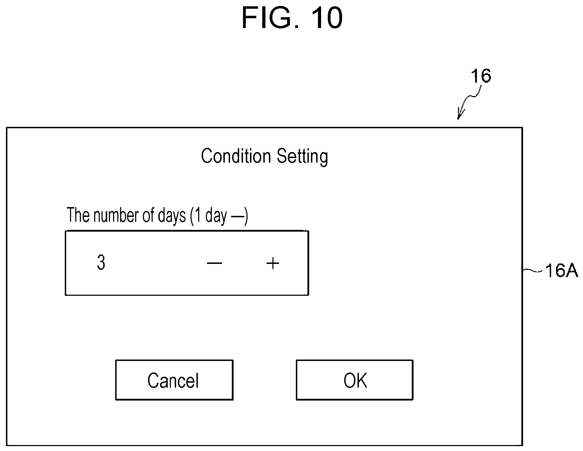

In the first to third exemplary embodiments, the example in which the setting condition is the number of jobs is described. However, the configuration is not limited to this form. For example, the setting condition may be the number of days as illustrated in Fig. 10, or may be a period.

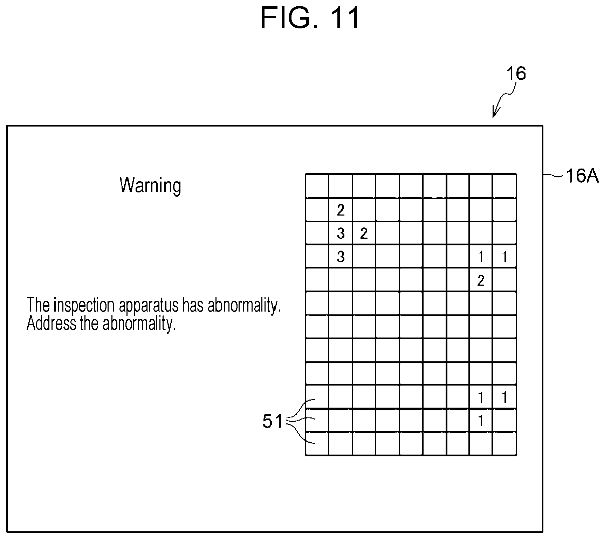

In the first to third exemplary embodiments, the example in which the notification unit 35 outputs a heat map 50 to the display 16A of the user terminal 16 and notifies a determination result from the inspection abnormality determining unit 35 is described. Alternatively, as illustrated in Fig. 11, the notification unit may output, to the display 16A of the user terminal 16, an illustration of the division-by-division-basis counts of abnormalities detected in an inspection, and may notify a determination result from the inspection abnormality determining unit 35.

In the first to third exemplary embodiments, the example in which, when the counting unit 34 resets the counting information, the process returns to step S101 is described. Alternatively, when the counting unit 34 resets the counting information, the notification unit may notify this and the process may return to step S101.

In the first to third exemplary embodiments, the example in which a user may input the setting condition to the information processing apparatus 20 by using the user terminal 16 is described. Alternatively, the setting condition may be set in advance before shipment of the information processing system.

In the first to third exemplary embodiments, the example in which the information processing system 10 includes a single image forming apparatus 12 is described. Alternatively, the information processing system may include multiple image forming apparatuses 12.

### Appendix

(((1))) An information processing system comprising:
   a processor configured to:
   obtain instruction information for an image forming apparatus and an inspection result within a range of a setting condition which has been set in advance, the inspection result being obtained by an inspection apparatus which inspects an image formed on a recording medium by the image forming apparatus on a basis of the instruction information; and
   output an abnormality monitoring result obtained in accordance with division-by-division-basis counts of abnormalities in an inspection, the divisions being obtained by dividing an inspection area inspected by the inspection apparatus.
(((2))) The information processing system according to (((1))),
   wherein the processor is configured to:
   when a division-by-division-basis count among the division-by-division-basis counts of abnormalities in the inspection is greater than or equal to a specified number of inspections performed by the inspection apparatus, notify, as the abnormality monitoring result, possibility of an abnormality of the inspection apparatus.
(((3))) The information processing system according to (((1))),
   wherein the processor is configured to:
   when a ratio of a division-by-division-basis count among the division-by-division-basis counts of abnormalities in the inspection with respect to a count of inspections performed by the inspection apparatus is greater than or equal to a threshold, notify possibility of an abnormality of the inspection apparatus.
(((4))) The information processing system according to any one of (((1))) to (((3))),
   wherein the setting condition is a number of jobs or a number of days.
(((5))) The information processing system according to (((4))),
   wherein the processor is configured to:
   even in the middle of the number of jobs or in the middle of the number of days, notify possibility of an abnormality of the inspection apparatus on a basis of the division-by-division-basis counts of abnormalities in the inspection.
(((6))) The information processing system according to (((4))),
   wherein the processor is configured to:
   when abnormalities occur in an identical division across jobs whose number is within the number of jobs, or when abnormalities occur in an identical division across days whose number is within the number of days, notify possibility of an abnormality of the inspection apparatus.
(((7))) The information processing system according to any one of (((1))) to (((6))),
   wherein the processor is configured to:
   generate a heat map as the abnormality monitoring result on a basis of the division-by-division-basis counts of abnormalities in the inspection, and notify possibility of an abnormality of the inspection apparatus.
(((8))) The information processing system according to (((7))),
   wherein the heat map is formed of divisions, each of which is larger than each division obtained by dividing the inspection area.
(((9))) A program causing a computer to execute a process comprising:
   obtaining instruction information for an image forming apparatus and an inspection result within a range of a setting condition which has been set in advance, the inspection result being obtained by an inspection apparatus which inspects an image formed on a recording medium by the image forming apparatus on a basis of the instruction information; and
   outputting an abnormality monitoring result obtained in accordance with division-by-division-basis counts of abnormalities in an inspection, the divisions being obtained by dividing an inspection area inspected by the inspection apparatus.

Compared with the case in which abnormalities are detected only on the basis of the number of recording media having abnormalities detected in an inspection, the information processing system according to (((1))) causes an abnormality of the inspection apparatus to be found with high accuracy.

Compared with the case in which abnormalities are detected only on the basis of the number of recording media having abnormalities detected in an inspection, the information processing system according to (((2))) causes an abnormality of the inspection apparatus to be found with high accuracy.

Even in the case of recording media having different sizes, the information processing system according to (((3))) causes an abnormality of the inspection apparatus to be found with high accuracy.

Compared with the case in which the number of sheets on which images are to be formed is set to the setting condition, the information processing system according to (((4))) causes an abnormality of the inspection apparatus to be found with high accuracy.

Even in the case where a division-by-division-basis count of abnormalities detected in an inspection reaches the reference value in the middle of the set number of jobs or in the middle of the set number of days, the information processing system according to (((5))) causes possibility of an abnormality of the inspection apparatus to be notified.

Compared with the case in which an abnormality is determined only in a single job, the information processing system according to (((6))) causes suppression of possibility of erroneous notification of possibility of an abnormality of the inspection apparatus.

Compared with the case in which the division-by-division-basis counts of abnormalities in an inspection are displayed as numeric values, the information processing system according to (((7))) causes an abnormality of the inspection apparatus to be found with high accuracy.

Compared with the case in which a heat map is formed of small-size divisions as they are, the information processing system according to (((8))) causes a user to grasp the positions of abnormalities easily.

Compared with the case in which abnormalities are detected only on the basis of the number of recording media having abnormalities detected in an inspection, the program according to (((9))) causes an abnormality of the inspection apparatus to be found with high accuracy.

## Claims

1. An information processing system comprising:
a processor configured to:
obtain instruction information for an image forming apparatus and an inspection result within a range of a setting condition which has been set in advance, the inspection result being obtained by an inspection apparatus which inspects an image formed on a recording medium by the image forming apparatus on a basis of the instruction information; and
output an abnormality monitoring result obtained in accordance with division-by-division-basis counts of abnormalities in an inspection, the divisions being obtained by dividing an inspection area inspected by the inspection apparatus.

2. The information processing system according to claim 1,
wherein the processor is configured to:
when a division-by-division-basis count among the division-by-division-basis counts of abnormalities in the inspection is greater than or equal to a specified number of inspections performed by the inspection apparatus, notify, as the abnormality monitoring result, possibility of an abnormality of the inspection apparatus.

3. The information processing system according to claim 1,
wherein the processor is configured to:
when a ratio of a division-by-division-basis count among the division-by-division-basis counts of abnormalities in the inspection with respect to a count of inspections performed by the inspection apparatus is greater than or equal to a threshold, notify possibility of an abnormality of the inspection apparatus.

4. The information processing system according to any one of claims 1 to 3,
wherein the setting condition is a number of jobs or a number of days.

5. The information processing system according to claim 4,
wherein the processor is configured to:
even in the middle of the number of jobs or in the middle of the number of days, notify possibility of an abnormality of the inspection apparatus on a basis of the division-by-division-basis counts of abnormalities in the inspection.

6. The information processing system according to claim 4,
wherein the processor is configured to:
when abnormalities occur in an identical division across jobs whose number is within the number of jobs, or when abnormalities occur in an identical division across days whose number is within the number of days, notify possibility of an abnormality of the inspection apparatus.

7. The information processing system according to any one of claims 1 to 6,
wherein the processor is configured to:
generate a heat map as the abnormality monitoring result on a basis of the division-by-division-basis counts of abnormalities in the inspection, and notify possibility of an abnormality of the inspection apparatus.

8. The information processing system according to claim 7,
wherein the heat map is formed of divisions, each of which is larger than each division obtained by dividing the inspection area.

9. A program causing a computer to execute a process comprising:
obtaining instruction information for an image forming apparatus and an inspection result within a range of a setting condition which has been set in advance, the inspection result being obtained by an inspection apparatus which inspects an image formed on a recording medium by the image forming apparatus on a basis of the instruction information; and
outputting an abnormality monitoring result obtained in accordance with division-by-division-basis counts of abnormalities in an inspection, the divisions being obtained by dividing an inspection area inspected by the inspection apparatus.

10. An information processing method comprising:
obtaining instruction information for an image forming apparatus and an inspection result within a range of a setting condition which has been set in advance, the inspection result being obtained by an inspection apparatus which inspects an image formed on a recording medium by the image forming apparatus on a basis of the instruction information; and
outputting an abnormality monitoring result obtained in accordance with division-by-division-basis counts of abnormalities in an inspection, the divisions being obtained by dividing an inspection area inspected by the inspection apparatus.
